# EUROPEAN PATENT APPLICATION

(11) **EP 4 823 253 A1**
(43) Date of publication of application: **14.10.2026**
(21) Application number: 26166266.2
(22) Date of filing: 20.03.2026
(51) Int. Cl.: H05K 7/14, H04Q 1/00, H05K 5/00

(54) **POWER CONVERSION APPARATUS AND POWER CABINET**

(30) Priority: 21.03.2025 CN 202520512277 U
(71) Applicant: HUAWEI TECHNOLOGIES CO., LTD., Shenzhen 518129 (CN)
(72) Inventor: CAO, Wenyuan, Shenzhen, 518129 (CN); JIANG, Hongxu, Shenzhen, 518129 (CN); JIANG, Zhengdong, Shenzhen, 518129 (CN)
(74) Representative: Isarpatent

(57) **Abstract**

Embodiments of this application provide a power conversion apparatus and a power cabinet including the power conversion apparatus, and relate to the field of energy technologies. The power conversion apparatus is configured to perform power conversion on input electric energy for output. The power conversion apparatus includes an apparatus housing, a circuit board, a power device, and a substrate. The circuit board is fastened in the apparatus housing. The power device is fastened to the circuit board. The substrate is located in the apparatus housing. The substrate includes a first metal layer, a second metal layer, and a first insulation layer fastened between the first metal layer and the second metal layer. The first metal layer is connected to the circuit board or the power device. The substrate further includes a through hole and a conductor. The through hole goes through the first metal layer and the first insulation layer. The conductor penetrates the through hole and connects the first metal layer and the second metal layer. During operation of the power conversion apparatus, a voltage to ground of a part that is of the circuit board or the power device and that is configured to connect to the first metal layer remains unchanged.

## Description

### TECHNICAL FIELD

This application relates to the field of energy technologies, and in particular, to a power conversion apparatus and a power cabinet.

### BACKGROUND

Power conversion apparatuses are widely used in various power systems. A power device is a core of hardware design of a power conversion apparatus. However, the power device generates a considerable amount of heat during operation of the power conversion apparatus.

In a related technology, to effectively dissipate heat from the power device, a substrate for auxiliary heat dissipation is connected to a circuit board. In addition, to ensure that a structure (for example, a further auxiliary heat dissipation structure) connected to the substrate is not directly electrified, the substrate is configured as a multi-layer structure, and two metal layers of the substrate are insulated from each other through an insulation layer.

However, there is a large area of overlap between the two metal layers of the substrate, which may result in a large parasitic capacitance. A varying voltage on the circuit board may be conducted through the parasitic capacitance of the substrate to the structure connected to the substrate. This leads to a transient voltage on the substrate and the structure connected to the substrate, causing interference to a signal in the power conversion apparatus (for example, a signal from a drive circuit used to drive the power device, or a signal from a control circuit used to control the power device).

### SUMMARY

This application provides a power conversion apparatus and a power cabinet including the power conversion apparatus, to reduce interference to a signal in the power conversion apparatus while effectively dissipating heat from a power device.

To achieve the foregoing objective, this application uses the following technical solutions.

According to a first aspect of this application, a power conversion apparatus is provided. The power conversion apparatus is configured to perform power conversion on input electric energy for output. The power conversion apparatus includes an apparatus housing, a circuit board, a power device, and a substrate. The circuit board is fastened in the apparatus housing. The power device is fastened to the circuit board. The substrate is located in the apparatus housing. The substrate includes a first metal layer, a second metal layer, and a first insulation layer fastened between the first metal layer and the second metal layer. The first metal layer is connected to the circuit board or the power device. The substrate further includes a through hole and a conductor. The through hole goes through the first metal layer and the first insulation layer. The conductor penetrates the through hole and connects the first metal layer and the second metal layer. During operation of the power conversion apparatus, a voltage to ground of a part that is of the circuit board or the power device and that is configured to connect to the first metal layer remains unchanged.

The power conversion apparatus implements power conversion on the input electric energy by using the power device on the circuit board. During operation of the power conversion apparatus, the power device generates a considerable amount of heat, and the substrate can help with heat dissipation of the power device. Both the first metal layer and the second metal layer in the substrate have a strong heat conduction capability (metal has a good heat conduction capability), so that the heat from the power device can be transferred outward through the substrate, thereby effectively improving a heat dissipation effect of the power device. For example, when the substrate is connected to the power device, the heat from the power device is transferred to the substrate, and then transferred outward through the substrate. For another example, when the substrate is connected to the circuit board, the heat from the power device is transferred to the circuit board, then transferred to the substrate through the circuit board, and finally transferred outward through the substrate. Moreover, the first insulation layer of the substrate can separate the first metal layer from the second metal layer. This reduces a possibility that the first metal layer and the second metal layer are electrically connected to each other.

The substrate further includes a conductor. The conductor goes through the first metal layer and the first insulation layer, and the conductor connects the first metal layer and the second metal layer. Because the first metal layer is connected to the circuit board or the power device, the second metal layer may be electrically connected to the circuit board or the power device through the conductor. The voltage to ground of the part that is of the circuit board or the power device and that is configured to connect to the first metal layer remains unchanged (with a stable level and without a transient voltage), ensuring that a level of the second metal layer (or a structure connected to the second metal layer) is stable. This reduces interference to a signal in the power conversion apparatus (for example, a signal from a drive circuit used to drive the power device, or a signal from a control circuit used to control the power device), and improves electromagnetic compatibility (Electromagnetic Compatibility, EMC) inside the power conversion apparatus.

In conclusion, the substrate in this application can help with heat dissipation of the power device, which reduces a risk of interference to the signal in the power conversion apparatus caused by a transient voltage on the second metal layer (or the structure connected to the second metal layer) while effectively dissipating the heat from the power device.

In an embodiment of this application, the substrate is located on a side that is of the circuit board and that is away from the power device, the circuit board includes a routing layer facing the substrate, the routing layer is connected to the first metal layer, and a voltage to ground of a part that is of the routing layer and that is configured to connect to the first metal layer remains unchanged.

The conductor connects the first metal layer and the second metal layer, and the first metal layer is connected to the routing layer of the circuit board. In other words, the second metal layer is electrically connected to the routing layer through the conductor and the first metal layer, and the first metal layer is connected to the part that is of the routing layer and whose voltage to ground remains unchanged, thereby ensuring that the level of the second metal layer (or the structure connected to the second metal layer) is stable. In addition, the routing layer of the circuit board is connected to the first metal layer of the substrate. A material of the routing layer is metal, and the metallic routing layer can be soldered to the metallic first metal layer. This facilitates stable connection between the substrate and the circuit board, reducing a possibility that the substrate is separated from the circuit board. When the routing layer that is of the circuit board and that faces the substrate is soldered to the first metal layer of the substrate, solder used for the soldering serves as a thermal interface material (Thermal Interface Material, TIM), and has low thermal resistance, so that thermal resistance between the substrate and the circuit board is low, thereby facilitating heat transfer between the substrate and the circuit board.

In an embodiment of this application, the substrate is located on a side that is of the power device and that is away from the circuit board; and the power device includes a packaging housing, a die, and a metal plate, the die is located in the packaging housing and is electrically connected to the metal plate, the metal plate protrudes from the inside of the packaging housing to a side that is of the packaging housing and that is away from the circuit board, the metal plate is connected to the first metal layer, and a voltage to ground of the metal plate remains unchanged.

When the first metal layer of the substrate is connected to the power device, the heat from the power device can be directly transferred to the substrate (without passing through the circuit board), and then transferred outward through the substrate. This shortens a heat dissipation path of the power device and improves the heat dissipation effect of the power device. When the voltage to ground of the metal plate remains unchanged, the first metal layer being connected to the metal plate, and the first metal layer being connected to the second metal layer through the conductor can ensure that the level of the second metal layer (or the structure connected to the second metal layer) is stable, thereby reducing interference to a signal.

In addition, the metal plate of the power device can also help the power device dissipate heat outward, so that heat inside the packaging housing is quickly transferred to the outside of the packaging housing through the metal plate. In other words, the heat inside the packaging housing is quickly transferred to the substrate, thereby improving heat dissipation efficiency of the power device.

In an embodiment of this application, the die includes a switching transistor, a drain or a collector of the switching transistor is electrically connected to the metal plate, and the metal plate is electrically connected to a negative bus of a power conversion circuit in the power conversion apparatus.

Usually, the drain or the collector of the switching transistor in the die is electrically connected to the metal plate. When the metal plate is electrically connected to the negative bus, the voltage to ground of the metal plate remains unchanged. As a result, a level of the substrate connected to the metal plate is also stable. This reduces a risk of interference to the signal in the power conversion apparatus.

In an embodiment of this application, the power conversion apparatus further includes a heat sink. The heat sink is located in the apparatus housing or at least a part of the heat sink is located outside the apparatus housing. The heat sink includes a heat conducting plate and a plurality of fins. The heat conducting plate is located on a side that is of the substrate and that is away from the power device, and is connected to the second metal layer. The plurality of fins are fastened to a surface that is of the heat conducting plate and that is away from the substrate.

The second metal layer of the substrate is connected to the heat sink (heat sink, HSK). Because the level of the second metal layer is stable, a level of the heat sink is also stable. This reduces a possibility that there is a transient voltage on the substrate and the heat sink, and thereby reduces a risk of interference to the signal in the power conversion apparatus.

The heat sink can help the substrate dissipate heat. After the heat from the power device is transferred to the substrate, the heat is transferred to the heat conducting plate of the heat sink through the substrate, and the heat is transferred from the heat conducting plate to the plurality of fins. A gap between two adjacent fins facilitates heat exchange between the fins and air, thereby improving heat dissipation efficiency of the power device.

In addition, if a boss (a structure similar to a fin) is directly formed on the substrate, a length of the boss (a size of the boss in a thickness direction on the second metal layer) may be short due to a limitation of a manufacturing device of the substrate, which affects the heat dissipation effect of the power device. In addition, in the foregoing design manner, to make the length of the boss to meet a heat dissipation requirement of the power device, manufacturing costs are inevitably greatly increased. However, the heat sink is additionally provided, so that the heat sink can be independently produced according to a requirement. In this way, a size and a shape of the heat sink are more flexible, which is conducive to production and manufacturing. As a result, manufacturing costs are reduced while effective heat dissipation of the power device is maintained.

In an embodiment of this application, the through hole further goes through the second metal layer, and one end that is of the conductor and that is away from the circuit board is connected to the heat sink.

The through hole goes through the first metal layer, the first insulation layer, and the second metal layer. In other words, the through hole goes through the entire substrate. This facilitates processing of the through hole. In addition, when the through hole goes through the entire substrate, the conductor may also go through the second metal layer and be connected to the heat sink, thereby further improving stability of electrical connections between the heat sink, the second metal layer, and the first metal layer.

In an embodiment of this application, the substrate further includes a filler, the conductor is in a ring shape and is fastened to an inner surface of the through hole, and the filler is configured to be filled in space enclosed by the conductor.

The through hole and the conductor fastened to an inner wall of the through hole form a metal hole. In this case, the conductor is a metal layer in the through hole, and the space enclosed by the conductor is space inside the through hole. The through hole can be sealed by placing the filler in the space enclosed by the conductor. When the substrate needs to be connected to the circuit board or the heat sink through soldering, sealing the through hole with the filler reduces a possibility that solder between the circuit board and the substrate or solder between the substrate and the heat sink enters the through hole. This facilitates stable connection between the substrate and the circuit board or between the substrate and the heat sink.

In an embodiment of this application, the filler includes a metal block, and one end that is of the metal block and that is away from the circuit board is connected to the heat sink; or the filler includes resin.

When the filler is a metal block, because the metal block is made of metal and has a strong heat conduction capability, the metal block can quickly conduct heat from the substrate to the heat sink, thereby improving heat dissipation efficiency of the power device. When the filler is resin, because the resin has a stronger heat conduction capability than air, heat can also be quickly transferred through the resin. In this way, heat transfer is accelerated.

In an embodiment of this application, the substrate further includes a second insulation layer and a third metal layer that are located between the first insulation layer and the second metal layer, and the second insulation layer is fastened between the second metal layer and the third metal layer. The through hole further goes through the second insulation layer and the third metal layer, and the conductor is further connected to the third metal layer.

One side of the substrate needs to be connected to the power device or the circuit board, and the other side of the substrate may be connected to an auxiliary heat dissipation structure such as the heat sink. Therefore, materials of the first metal layer, the second metal layer, and the third metal layer may be separately selected. For example, materials of metal layers on two sides of the substrate (the material of the first metal layer and the material of the second metal layer) are materials conducive to soldering (for example, copper); and a material of a metal layer at the middle of the substrate (the material of the third metal layer) is a material with a lower cost (for example, aluminum), or the material of the third metal layer is a material with a lighter weight.

The substrate includes a plurality of metal layers (the first metal layer, the second metal layer, and the third metal layer). Different materials may be selected for different metal layers according to a requirement. This facilitates connection (for example, soldering) between the substrate and another structure, with other factors such as cost, weight, and heat conduction capability of the substrate taken into consideration, allowing for a more flexible design of the substrate. In addition, when the substrate includes the plurality of metal layers, a plurality of insulation layers (the first insulation layer and the second insulation layer) are further provided. This reduces a possibility that adjacent metal layers are electrically connected to each other.

Moreover, when the substrate includes the plurality of metal layers, the through hole goes through at least the first metal layer, the first insulation layer, the third metal layer, and the second insulation layer, so that the conductor can connect the first metal layer, the second metal layer, and the third metal layer. In this way, when a voltage to ground of a structure connected to the first metal layer remains unchanged, the level of the second metal layer and a level of the third metal layer may be stable.

In an embodiment of this application, a thickness of the first metal layer and a thickness of the second metal layer are both greater than a thickness of the first insulation layer.

Both the first metal layer and the second metal layer in the substrate have a strong heat conduction capability, and the first insulation layer for shielding has a weak heat conduction capability. Therefore, in some scenarios, the thickness of the first metal layer and the thickness of the second metal layer may be increased, and the thickness of the first insulation layer may be decreased, to improve a heat conduction capability of the substrate and facilitate heat dissipation of the power device.

In an embodiment of this application, a material of the first insulation layer includes polypropylene.

Polypropylene (PP) has good insulation performance, and has a stronger heat conduction capability than another insulation material (for example, polyimide). The first insulation layer of the substrate includes polypropylene. In this way, the first metal layer and the second metal layer are insulated from each other, thermal resistance between the first metal layer and the second metal layer is reduced, and a heat dissipation capability of the substrate is improved.

According to a second aspect of this application, a power cabinet is provided. The power cabinet includes a cabinet body and a plurality of power conversion apparatuses. The plurality of power conversion apparatuses are located in the cabinet body, and the plurality of power conversion apparatuses are connected in parallel.

The power conversion apparatus in the cabinet body can perform power conversion on input electric energy for output. The substrate can help with heat dissipation of the power device, and can reduce a risk of interference to a signal in the power conversion apparatus caused by a transient voltage on the second metal layer (or the structure connected to the second metal layer). The power cabinet provided in this application includes the foregoing power conversion apparatus. Therefore, the power cabinet provided in this application and the power conversion apparatus in the foregoing technical solution can resolve the same technical problem and have same technical effects. Details are not described herein again.

### BRIEF DESCRIPTION OF DRAWINGS

FIG. 1 is a diagram of a structure of a power conversion apparatus according to an embodiment of this application;
FIG. 2 is a diagram of a structure of a power cabinet according to an embodiment of this application;
FIG. 3 is a diagram of a structure of another power cabinet according to an embodiment of this application;
FIG. 4 is a diagram of an internal structure of a power conversion apparatus according to an embodiment of this application;
FIG. 5 is a diagram of an internal structure of another power conversion apparatus according to an embodiment of this application;
FIG. 6 is a diagram of a structure and a location of a substrate according to an embodiment of this application;
FIG. 7 is a diagram of a structure of a through hole and a structure of a conductor according to an embodiment of this application;
FIG. 8 is a diagram of a structure of a filler according to an embodiment of this application;
FIG. 9 is a diagram of a structure and a location of a heat sink according to an embodiment of this application;
FIG. 10 is a diagram of an internal structure of still another power conversion apparatus according to an embodiment of this application;
FIG. 11 is a diagram of an internal structure of still another power conversion apparatus according to an embodiment of this application;
FIG. 12 is a diagram of a structure of a through hole according to an embodiment of this application;
FIG. 13 is a diagram of a location of another substrate according to an embodiment of this application;
FIGS. 14A and 14B are diagrams of structures of two power devices according to an embodiment of this application;
FIG. 15 is a topology diagram of a direct current-direct current power conversion circuit according to an embodiment of this application;
FIG. 16 is a diagram of a structure and a location of another heat sink according to an embodiment of this application;
FIG. 17 is a diagram of a location of another substrate according to an embodiment of this application;
FIG. 18 is a diagram of a structure of another substrate according to an embodiment of this application; and
FIG. 19 is a diagram of a structure of still another substrate according to an embodiment of this application.

### Reference numerals:

100: power conversion apparatus; 1: apparatus housing; 11: opening; 2: circuit board; 21: routing layer; 22: heat dissipation hole; 3: power device; 31: packaging housing; 32: die; 321: switching transistor; 33: metal plate; 34: pin; 35: mounting plate; 36: conductive structure; 4: main board; 5: substrate; 51: first metal layer; 52: first insulation layer; 53: second metal layer; 54: through hole; 55: conductor; 56: filler; 57: second insulation layer; 58: third metal layer; 59: boss; 6: heat sink; 61: heat conducting plate; 62: fin; 7: solder; 8: direct current-direct current power conversion circuit; 81: positive bus; 82: negative bus; 200: power cabinet; 201: cabinet body; 202: circuit breaker; 203: charging connector; 204: cable.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

In this application, the terms "first", "second", and the like are merely intended for a purpose of description, and are intended to distinguish between one element and another element, but cannot be understood as an indication or implication of relative importance or an implicit indication of a quantity of indicated technical features. Therefore, a feature limited by "first", "second", or the like may explicitly or implicitly include one or more features.

In addition, in this application, the term "example", "for example", or the like indicates giving an example, an illustration, or a description. Any embodiment or design scheme described as an "example" or "for example" in this application should not be construed as being more preferred or having more advantages than another embodiment or design scheme. To be precise, use of the terms such as "example" or "for example" is intended to present a related concept in a specific manner.

In the accompanying drawings of embodiments of this application, entity structures such as components and assemblies are represented by guide lines. A structure including a plurality of components is represented by parentheses or guide lines with solid arrows. Hollow structures such as openings, holes, spaces, and chambers are represented by guide lines with hollow arrows.

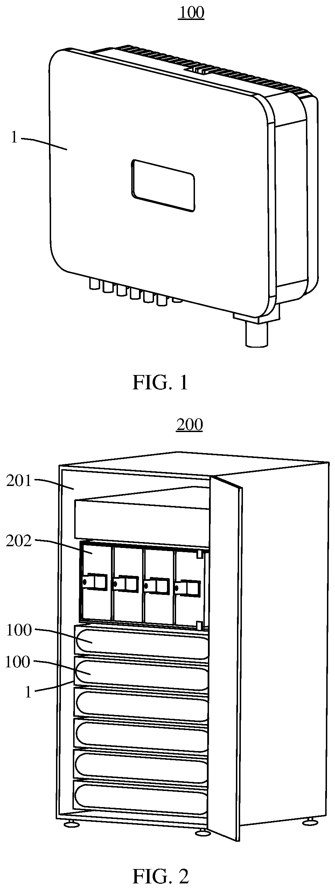

Embodiments of this application provide a power conversion apparatus 100. The power conversion apparatus 100 performs power conversion on input electric energy through an internal power conversion circuit for output. For example, the power conversion apparatus 100 can convert a direct current into an alternating current. For another example, the power conversion apparatus 100 can convert an alternating current into a direct current. For another example, the power conversion apparatus 100 can perform boost or buck conversion. The power conversion apparatus 100 in this application may be an inverter, a rectifier, an on-board charger (On-Board Charger, OBC), a power module (for example, a DC-DC module or an AC-DC module) in a charging pile, a small charging apparatus, or the like. FIG. 1 shows an example of a structure of a power conversion apparatus 100. With reference to FIG. 1, the power conversion apparatus 100 may be a rectifier.

In addition, the power conversion apparatus 100 may be further used in a power cabinet 200. For example, FIG. 2 shows an example of a structure of one power cabinet 200. With reference to FIG. 2, the power cabinet 200 may be a cabinet-type uninterruptible power supply (Uninterruptible Power Supply, UPS). The power cabinet 200 includes a cabinet body 201, a plurality of power conversion apparatuses 100 connected in parallel, a plurality of circuit breakers 202, and the like. The plurality of power conversion apparatuses 100 may include a plurality of AC-DC modules; or the plurality of power conversion apparatuses 100 may include a plurality of DC-DC modules and a plurality of AC-DC modules. The plurality of power conversion apparatuses 100 are stacked in the cabinet body 201 along a height direction of the cabinet body 201, and the plurality of circuit breakers 202 are located above the plurality of power conversion apparatuses 100.

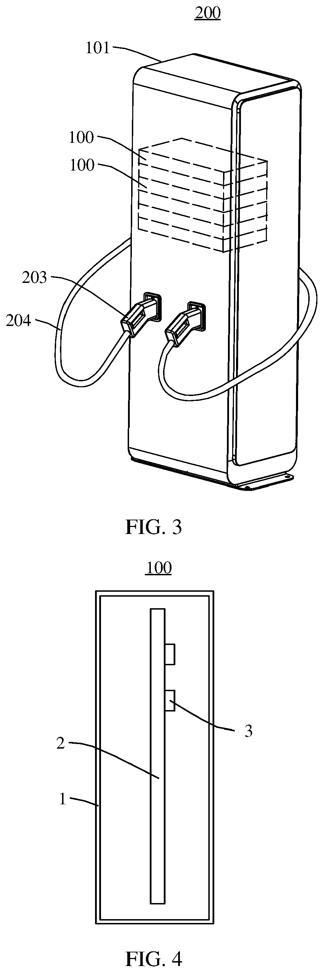

For another example, FIG. 3 shows an example of a structure of another power cabinet 200. With reference to FIG. 3, the power cabinet 200 may alternatively be a charging pile. The power cabinet 200 includes a cabinet body 201, a plurality of power conversion apparatuses 100 connected in parallel, at least one charging connector 203 (a plurality of charging connectors 203 are shown in FIG. 3), at least one cable 204 (a plurality of cables 204 are shown in FIG. 3), and the like. The plurality of power conversion apparatuses 100 connected in parallel are located in the cabinet body 201 of the power cabinet 200. The charging connector 203 is electrically connected to output ends of the plurality of power conversion apparatuses 100 through corresponding cables 204.

FIG. 4 shows an example of an internal structure of a power conversion apparatus 100. With reference to FIG. 4, the power conversion apparatus 100 includes an apparatus housing 1. The apparatus housing 1 may be any housing with a housing function. In addition, the power conversion apparatus 100 further includes a circuit board 2 and a power device 3 fastened to the circuit board 2. For example, the circuit board 2 is a printed circuit board (printed circuit board, PCB), and the power device 3 is fastened (for example, soldered) to the circuit board 2 and is connected to a trace on a surface of the circuit board 2. Both the circuit board 2 and the power device 3 are located in the apparatus housing 1.

In some embodiments, the power device 3 may be in a form of surface-mount device. This facilitates development of the power device 3 toward miniaturization and high density, and can also improve reliability of the power device 3. The power device 3 in the form of surface-mount device may be soldered to a pad of the circuit board 2 (the pad may be an exposed part of a trace of the circuit board 2), and a pin of the power device 3 is fastened to a surface that is of the pad and that faces the power device 3. In some other embodiments, the power device 3 may alternatively be another suitable packaged device.

In the embodiment shown in FIG. 4, at least a part of the power conversion circuit in the power conversion apparatus 100 is disposed on the circuit board 2. The power conversion circuit includes the power device 3, a drive circuit for driving the power device 3, a control circuit for controlling the power device 3, and the like.

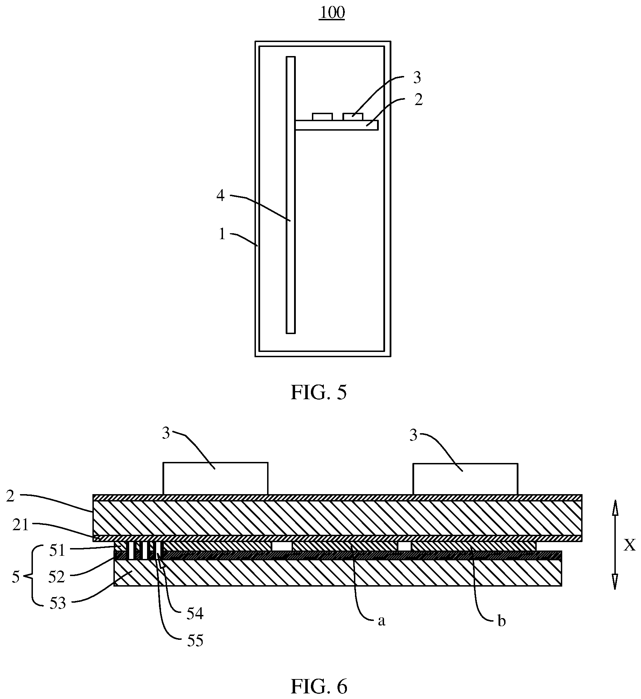

FIG. 5 shows an example of an internal structure of another power conversion apparatus 100. With reference to FIG. 5, a difference from the embodiment shown in FIG. 4 is that the circuit board 2 to which the power device 3 is fastened is fastened to another circuit board (which may be named a main board 4) through an adapter structure (for example, a pin or a metal part). In the embodiment shown in FIG. 5, a part of power devices 3 of a power conversion circuit are disposed on the circuit board 2, and another device of the power conversion circuit, such as an inductor or a capacitor, is disposed on the another circuit board (the main board 4). In addition, a control circuit for controlling the power device 3 and the like are further disposed on the another circuit board (the main board 4).

The circuit board 2 to which the power device 3 is fastened and the another circuit board (the main board 4) may be mounted at any proper angle. For example, in the embodiment shown in FIG. 5, the circuit board 2 to which the power device 3 is fastened is vertically fastened to the another circuit board (the main board 4). In other words, either surface of the circuit board 2 to which the power device 3 is fastened is perpendicular ("perpendicular" herein does not indicate absolute perpendicularity but allows for a tolerance of ±10°) to either surface of the another circuit board (the main board 4). In some other embodiments, the circuit board 2 to which the power device 3 is fastened is parallel to the another circuit board (the main board 4). In other words, either surface of the circuit board 2 to which the power device 3 is fastened is parallel ("parallel" herein allows for a tolerance of ±10°) to either surface of the another circuit board (the main board 4).

During operation of the power conversion apparatus 100, the power device 3 generates a considerable amount of heat. Therefore, in this application, the power conversion apparatus 100 further includes a substrate 5, and the substrate 5 helps with heat dissipation of the power device 3. FIG. 6 shows an example of a structure and a location of the substrate 5. With reference to FIG. 6, the substrate 5 is located in the apparatus housing 1 (for a structure of the apparatus housing 1, refer to FIG. 4 or FIG. 5). Still with reference to FIG. 6, the substrate 5 includes a first metal layer 51, a first insulation layer 52, and a second metal layer 53, the first insulation layer 52 is fastened between the first metal layer 51 and the second metal layer 53, and the first metal layer 51 is connected to the circuit board 2.

The first metal layer 51 and the second metal layer 53 are both made of metal, and have a strong heat conduction capability. Heat from the power device 3 is transferred to the circuit board 2, and then from the circuit board 2 to the substrate 5. The heat is transferred outward through the substrate 5 that has a strong heat conduction capability. Materials of the first metal layer 51 and the second metal layer 53 may be any suitable metal materials, and the materials of first metal layer 51 and the second metal layer 53 may be the same or different, provided that the first metal layer 51 and the second metal layer 53 are both made of metal. In some embodiments, if the first metal layer 51 needs to be soldered to the circuit board 2, the material of the first metal layer 51 may be a metal material conducive to soldering, for example, copper. In some other embodiments, if costs or a weight needs to be controlled, the material of the second metal layer 53 may be a material that meets design requirements, for example, aluminum. In some other embodiments, if another structure (for example, an auxiliary heat dissipation structure) needs to be connected to the second metal layer 53, the material of the second metal layer 53 may be a metal material conducive to soldering, for example, copper, or the material of the second metal layer 53 may be a metal material not conducive to soldering (the material is selected for another purpose, for example, cost, weight, heat conduction capability, or the like), and electroplating is performed on a surface that is of the second metal layer 53 and that needs to be soldered to the another structure (for example, a surface that is of the second metal layer 53 and that is away from the first insulation layer 52), so that the surface of the second metal layer 53 is electroplated with a material conducive to soldering. This facilitates fastening by soldering between the second metal layer 53 and the another structure.

Moreover, the first insulation layer 52 of the substrate 5 can separate the first metal layer 51 from the second metal layer 53. This reduces a possibility that the first metal layer 51 and the second metal layer 53 are electrically connected to each other. A material of the first insulation layer 52 may be any suitable insulation material. For example, the material of the first insulation layer 52 includes polypropylene (PP). In other words, the first insulation layer 52 is a PP layer. Polypropylene has good insulation performance, and has a stronger heat conduction capability than another insulation material (for example, polyimide). The first insulation layer 52 of the substrate 5 includes polypropylene. In this way, the first metal layer 51 and the second metal layer 53 are insulated from each other, thermal resistance between the first metal layer 51 and the second metal layer 53 is reduced, and a heat dissipation capability of the substrate 5 is improved.

Both the first metal layer 51 and the second metal layer 53 in the substrate 5 have a strong heat conduction capability, and the first insulation layer 52 for separating the first metal layer 51 from the second metal layer 53 has a weak heat conduction capability. Therefore, in some embodiments, with reference to FIG. 6, a thickness of the first metal layer 51 and a thickness of the second metal layer 53 may be large, and a thickness of the first insulation layer 52 may be small, to improve the heat conduction capability of the substrate 5. For example, the thickness of the first metal layer 51 and the thickness of the second metal layer 53 are both greater than the thickness of the first insulation layer 52. In some other embodiments, the thickness of the first metal layer 51 may be equal to the thickness of the first insulation layer 52 or less than the thickness of the first insulation layer 52.

It should be noted that, the thickness of the first metal layer 51, the thickness of the first insulation layer 52, and the thickness of the second metal layer 53 are sizes of the three layers in thickness directions of the first metal layer 51, the first insulation layer 52, and the second metal layer 53 (an X direction in FIG. 6).

However, there is a large area of overlap between the first metal layer 51 and the second metal layer 53 that are of the substrate 5, which may result in a large parasitic capacitance. A varying voltage on the circuit board 2 may be conducted through the parasitic capacitance of the substrate 5 to a structure connected to the substrate 5. This leads to a transient voltage on the substrate 5 and the structure connected to the substrate 5, causing interference to a signal in the power conversion apparatus 100 (for example, a signal from a drive circuit used to drive the power device 3, or a signal from a control circuit used to control the power device 3).

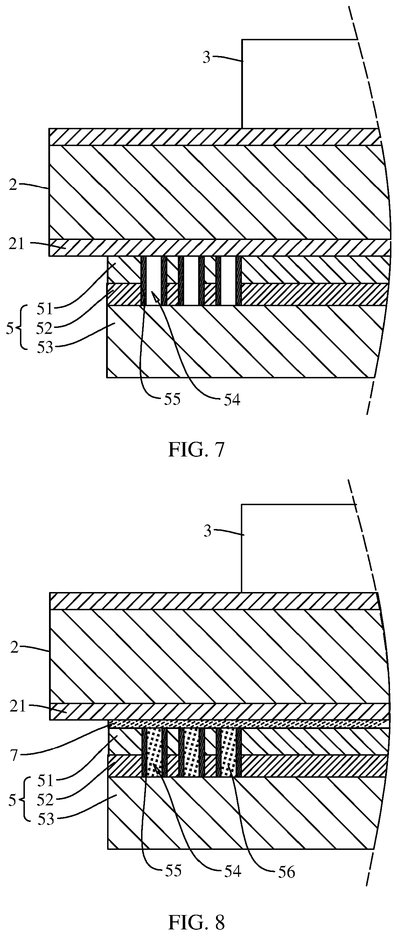

Therefore, the substrate 5 further includes a through hole 54 and a conductor 55. FIG. 7 shows an example of structures of the through hole 54 and the conductor 55. The through hole 54 goes through the first metal layer 51 and the first insulation layer 52, and the conductor 55 penetrates the through hole 54 and connects the first metal layer 51 and the second metal layer 53. In addition, during operation of the power conversion apparatus 100, a voltage to ground (for example, a potential difference between an electrified part and the ground, with the ground as a reference point) of a part that is of the circuit board 2 and that is configured to connect to the first metal layer 51 remains unchanged. In this application, a voltage to ground remaining unchanged means that the voltage remains at a stable level without a transient voltage.

With reference to FIG. 7, the conductor 55 connects the first metal layer 51 and the second metal layer 53. Because the first metal layer 51 is connected to the circuit board 2, the second metal layer 53 may be electrically connected to the circuit board 2 through the conductor 55 and the first metal layer 51. The voltage to ground of the part that is of the circuit board 2 and that is configured to connect to the first metal layer 51 remains unchanged. Therefore, a level of the second metal layer 53 (or a structure connected to the second metal layer 53) is stable. This reduces interference to the signal in the power conversion apparatus 100, and improves electromagnetic compatibility inside the power conversion apparatus 100.

In other words, the substrate 5 in this application is used, thereby reducing a risk of interference to the signal in the power conversion apparatus 100 caused by a transient voltage on the second metal layer 53 (or the structure connected to the second metal layer 53) while effectively dissipating the heat from the power device 3.

The conductor 55 may be any suitable metal structure. In some embodiments, with reference to FIG. 7, the conductor 55 is in a ring shape and is fastened to an inner surface of the through hole 54, so that a metal layer is formed on the inner surface of the through hole 54. The through hole 54 and the conductor 55 form a metal hole. The conductor 55 connects the first metal layer 51 and the second metal layer 53. In addition, in some embodiments, one end that is of the conductor 55 and that is away from the second metal layer 53 extends to the outside of the substrate 5 and is connected to the circuit board 2. In some other embodiments, the conductor 55 may be a metal post, a metal block, or another structure that can conduct electricity, one end of the conductor 55 is connected to the second metal layer 53, and the other end of the conductor 55 is connected to the first metal layer 51.

It should be noted that, in some embodiments, there may be a plurality of metal layers between the first insulation layer 52 and the circuit board 2, and the plurality of metal layers each are connected to the circuit board 2. The plurality of metal layers are insulated from each other, and form, on a surface of the substrate 5, a structure similar to a trace. For example, in FIG. 6, the plurality of metal layers between the first insulation layer 52 and the circuit board 2 include the first metal layer 51, a metal layer a, a metal layer b, and the like. However, the first metal layer 51 in this application is a metal layer that is provided with the through hole 54 and has the conductor 55. In some other embodiments, a metal layer between the first insulation layer 52 and the circuit board 2 includes only the first metal layer 51.

The part that is of the circuit board 2 and that is configured to connect to the first metal layer 51 may be a trace with a stable level on the circuit board 2. For example, the circuit board 2 includes a routing layer 21 (including a plurality of traces) facing the substrate 5, the first metal layer 51 is connected to the routing layer 21, and a voltage to ground of a part that is of the routing layer 21 and that is configured to connect to the first metal layer 51 remains unchanged. It may be understood that the foregoing routing layer 21 is a routing layer 21 that is of the circuit board 2 and that faces the substrate 5. In addition, the circuit board 2 further includes a trace for connecting to the power device 3. In some embodiments, the circuit board 2 is a multi-layer circuit board 2, and the circuit board 2 includes a plurality of layers of traces.

When the substrate 5 needs to be connected to the circuit board 2 through soldering, in some embodiments, the through hole 54 may further be sealed, and the substrate 5 further includes a filler 56. FIG. 8 shows an example of a structure of the filler 56. The through hole 54 is sealed by using the filler 56. With reference to FIG. 8, the conductor 55 is a metal layer in the through hole 54, and space enclosed by the conductor 55 is space inside the through hole 54, the filler 56 is placed in the space enclosed by the conductor 55, so that the through hole 54 can be sealed. This reduces a possibility that solder 7 between the circuit board 2 and the substrate 5 enters the through hole 54, so that the substrate 5 can be stably connected to the routing layer 21 of the circuit board 2. A material of the filler 56 may be any suitable material. For example, the filler 56 may be a metal block or resin that is conducive to heat transfer, or the like.

In some other embodiments, the filler 56 may not be placed in the through hole 54, and the conductor 55 may be filled in the through hole 54.

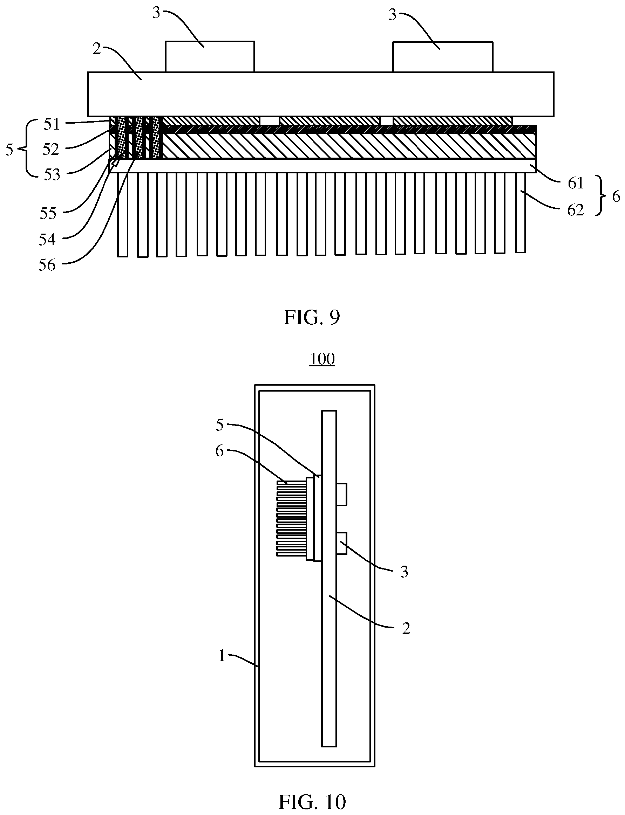

In some embodiments, a structure that helps with heat dissipation of the substrate 5 may be further disposed. For example, the power conversion apparatus 100 includes a heat sink 6. FIG. 9 shows an example of a location of the heat sink 6. The substrate 5 in FIG. 9 is located on a side that is of the circuit board 2 and that is away from the power device 3. The heat sink 6 includes a heat conducting plate 61 and a plurality of fins 62. The heat conducting plate 61 is located on a side that is of the substrate 5 and that is away from the power device 3, and is fastened to the substrate 5. For example, the heat conducting plate 61 is fastened to a second metal layer 53. The plurality of fins 62 are fastened to a surface that is of the heat conducting plate 61 and that is away from the substrate 5.

The substrate 5 may be connected to the heat conducting plate 61 of the heat sink 6 in any manner. For example, the substrate 5 is soldered to the heat conducting plate 61. Through soldering, which is a simple connection manner, the heat sink 6 can be stably connected to the substrate 5 and therefore help the substrate 5 dissipate heat. After the heat from the power device 3 is transferred to the substrate 5, the heat is transferred to the heat conducting plate 61 of the heat sink 6 through the substrate 5, and the heat is transferred from the heat conducting plate 61 to the plurality of fins 62. A gap between two adjacent fins 62 facilitates heat exchange between the fins 62 and air, thereby improving heat dissipation efficiency of the power device 3.

In addition, if a structure similar to the fins 62 is directly formed on the substrate 5, a length of the structure (a size of the structure in a thickness direction of the second metal layer 53) may be short due to a limitation of a manufacturing device of the substrate 5, which affects the heat dissipation effect of the power device 3. Therefore, to make the structure similar to the fins 62 on the substrate 5 meet a heat dissipation requirement of the power device 3, it is necessary to extend the length of the structure in another manner, which also increases manufacturing costs. However, the heat sink 6 is additionally provided, so that the heat sink 6 can be independently produced according to a requirement. In this way, a size and a shape of the heat sink 6 are more flexible, which is conducive to production and manufacturing. As a result, manufacturing costs are reduced while effective heat dissipation of the power device 3 is maintained.

In some embodiments, with reference to FIG. 9, the through hole 54 further goes through the second metal layer 53. The through hole 54 goes through the first metal layer 51, the first insulation layer 52, and the second metal layer 53. In other words, the through hole 54 goes through the entire substrate 5. This facilitates processing of the through hole 54. In addition, when the through hole 54 goes through the entire substrate 5, the conductor 55 may also go through the second metal layer 53, and one end that is of the conductor 55 and that is away from the circuit board 2 is connected to the heat sink 6. This further improves stability of electrical connections between the heat sink 6, the first metal layer 51, and the second metal layer 53. When the first metal layer 51 is connected to the circuit board 2, the heat sink 6, the first metal layer 51, and the second metal layer 53 each are electrically connected to the circuit board 2. Because the voltage to ground of the part that is of the circuit board 2 and that is configured to connect to the first metal layer 51 remains unchanged, the heat sink 6 has a stable level, and therefore the heat sink 6 is also in a state with a stable level. This reduces a possibility of a transient voltage on the substrate 5 and the heat sink 6, and thereby reduces a risk of interference to the signal in the power conversion apparatus 100.

When the substrate 5 is connected to the heat sink 6, the filler 56 may be placed in the through hole 54. When the filler 56 is a metal block, one end that is of the metal block and that is away from the circuit board 2 is connected to the heat sink 6. Because the metal block is made of metal, which has a strong heat conduction capability, the metal block can quickly conduct heat from the substrate 5 to the heat sink 6, thereby improving heat dissipation efficiency of the power device 3. Moreover, one end of the metal block may be connected to a trace that is of the circuit board 2 and whose voltage to ground remains unchanged, and the other end of the metal block may be connected to the heat sink 6, to make the electrical connection between the heat sink 6 and the circuit board 2 more stable. In addition, when the filler 56 is resin, because the resin has a stronger heat conduction capability than air, heat can also be quickly transferred through the resin. In this way, heat transfer is accelerated.

In some embodiments, when the substrate 5 is not connected to the heat sink 6, the through hole 54 may also go through the entire substrate 5.

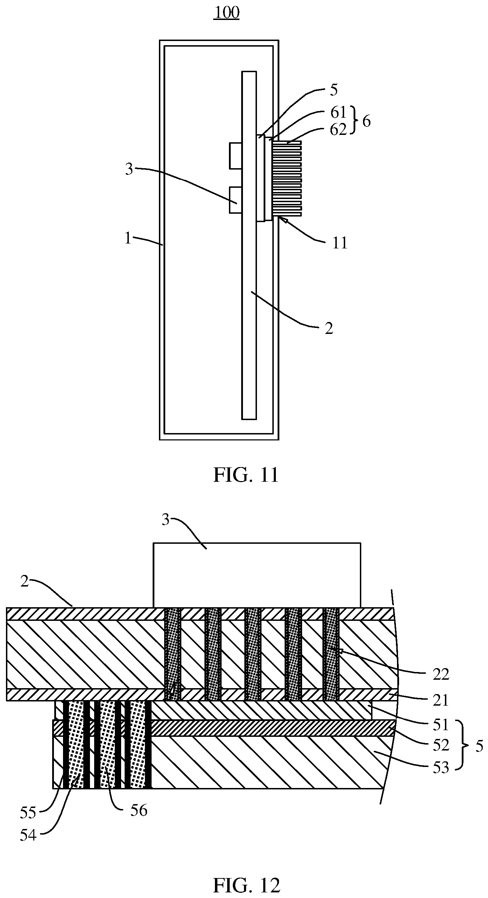

When the power device 3 further includes the heat sink 6, a location of the heat sink 6 relative to the apparatus housing 1 may be set according to a requirement. For example, FIG. 10 shows an example of a diagram of an internal structure of still another power conversion apparatus 100. With reference to FIG. 10, the heat sink 6 is located in the apparatus housing 1. For another example, FIG. 11 is an example of a diagram of an internal structure of still another power conversion apparatus 100. With reference to FIG. 11, an opening 11 is provided on the apparatus housing 1, a part of a heat sink 6 is in the apparatus housing 1, and another part (for example, a plurality of fins 62) of the heat sink 6 extends to the outside of the apparatus housing 1 through the opening 11.

In some embodiments, a hole may be further provided to accelerate heat transfer between the power device 3 and the substrate 5. For example, the circuit board 2 includes a heat dissipation hole 22. FIG. 12 shows an example of a structure of the heat dissipation hole 22. With reference to FIG. 12, the heat dissipation hole 22 is located between the power device 3 and the substrate 5, one port of the heat dissipation hole 22 faces the power device 3, and the other port of the heat dissipation hole 22 faces the substrate 5, so that heat conduction between the power device 3 and the substrate 5 can be accelerated. In this way, the heat from the power device 3 can be quickly transferred across the circuit board 2 to the substrate 5, and then the heat is transferred outward through the substrate 5, thereby improving heat dissipation efficiency of the power device 3.

The heat dissipation hole 22 may be any suitable hole-like structure. For example, with reference to FIG. 12, the heat dissipation hole 22 is a metal hole, and an inner surface of the heat dissipation hole 22 is provided with a metal layer. In addition, the heat dissipation hole 22 may be further filled with a material that has a strong heat conduction capability, and heat transfer can be further accelerated by filling with the material that has a strong heat conduction capability. In addition, the heat dissipation hole 22 can be sealed by filling the heat dissipation hole 22 with some materials. For example, when the heat dissipation hole 22 goes through the pad on the circuit board 2, filling the heat dissipation hole 22 can reduce a possibility that a soldering material on the pad enters the heat dissipation hole 22. This facilitates stable connection between the power device 3 and the circuit board 2.

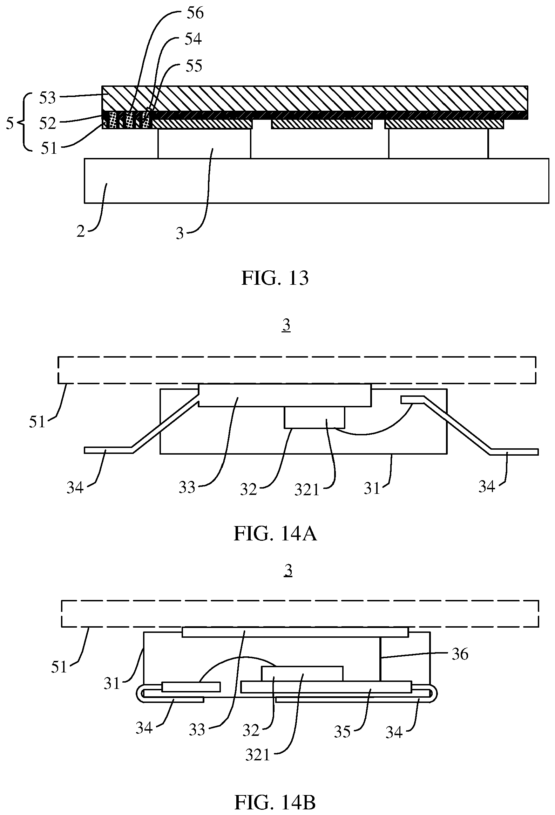

In some other embodiments, the substrate 5 may alternatively be connected to the power device 3. For example, FIG. 13 shows an example of a location of another substrate 5. With reference to FIG. 13, the substrate 5 is located on a side that is of the power device 3 and that is away from the circuit board 2, and a first metal layer 51 of the substrate 5 is connected to the power device 3. In this way, the heat from the power device 3 is directly transferred to the substrate 5 (without passing through the circuit board 2), and then transferred outward through the substrate 5. This shortens a heat dissipation path of the power device 3 and improves a heat dissipation effect of the power device 3.

With reference to FIG. 13, the substrate 5 further includes a through hole 54 and a conductor 55. The through hole 54 goes through the first metal layer 51 and the first insulation layer 52, and the conductor 55 penetrates the through hole 54 and connects the first metal layer 51 and the second metal layer 53. During operation of the power conversion apparatus 100, a voltage to ground of a part that is of the power device 3 and that is configured to connect to the first metal layer 51 remains unchanged. The first metal layer 51 is connected to the second metal layer 53 through the conductor 55. As a result, the level of the second metal layer 53 is stable, and interference to a signal is reduced. In the embodiment shown in FIG. 13, a filler 56 is placed in the through hole 54. In some other embodiments, the filler 56 may not be placed in the through hole 54.

FIGS. 14A and 14B show an example of structures of two power devices 3. With reference to FIG. 13 and FIG. 14A, the power device 3 includes a packaging housing 31, a die (die) 32, and a metal plate 33. The die 32 is located in the packaging housing 31, and the die 32 is fastened to the metal plate 33. Each die 32 includes at least one switching transistor 321. The switching transistor 321 may be an insulated gate bipolar transistor (IGBT), or the switching transistor 321 may be a metal-oxide-semiconductor field-effect transistor (MOSFET). Each switching transistor 321 includes a control electrode, a first electrode, and a second electrode. For example, when the switching transistor 321 is an insulated gate bipolar transistor (IGBT), the first electrode of the switching transistor 321 is a collector (a C electrode), the second electrode of the switching transistor 321 is an emitter (an E electrode), and the control electrode of the switching transistor 321 is a base (a B electrode). For another example, when the switching transistor 321 is a metal-oxide-semiconductor field-effect transistor (MOSFET), the first electrode of the switching transistor 321 is a drain (a D electrode), the second electrode of the switching transistor 321 is a source (an S electrode), and the control electrode of the switching transistor 321 is a gate (a G electrode).

With reference to FIG. 13 and FIG. 14A, the metal plate 33 protrudes from the inside of the packaging housing 31 to the outside of the packaging housing 31 (a side that is of the packaging housing 31 and that is away from the circuit board 2), and a part that is of the metal plate 33 and that protrudes to the outside of the packaging housing 31 is connected to the first metal layer 51. Because the die 32 is fastened to the metal plate 33, the first electrode or the second electrode of the die 32 may be electrically connected to the metal plate 33, and the metal plate 33 may be electrified. When a voltage to ground of the metal plate 33 remains unchanged, the first metal layer 51 is connected to the metal plate 33, and the first metal layer 51 is connected to the second metal layer 53 through the conductor 55, so that the level of the second metal layer 53 can be stable, and interference to a signal can be reduced.

In addition, the metal plate 33 of the power device 3 can also help the power device 3 dissipate heat outward, so that heat inside the packaging housing 31 is quickly transferred to the outside of the packaging housing 31 through the metal plate 33. In other words, the heat inside the packaging housing 31 is quickly transferred to the substrate 5, thereby improving heat dissipation efficiency of the power device 3.

Still with reference to FIG. 13 and FIG. 14A, the power device 3 further includes a plurality of pins 34, the plurality of pins 34 are configured to connect to the circuit board 2, and at least one pin 34 is connected to the metal plate 33.

In some other embodiments, with reference to FIG. 13 and FIG. 14B, the metal plate 33 may not be a plate for fastening the die 32, and the die 32 is fastened to a dedicated mounting plate 35. For example, the mounting plate 35 is a ceramic copper-clad plate (Direct Copper Bond, DCB). In these embodiments, the metal plate 33 is electrically connected to the mounting plate 35 through a conductive structure 36. In this way, the metal plate 33 is electrically connected to the die 32 through the conductive structure 36 and the mounting plate 35. Therefore, the level of the second metal layer 53 is stable.

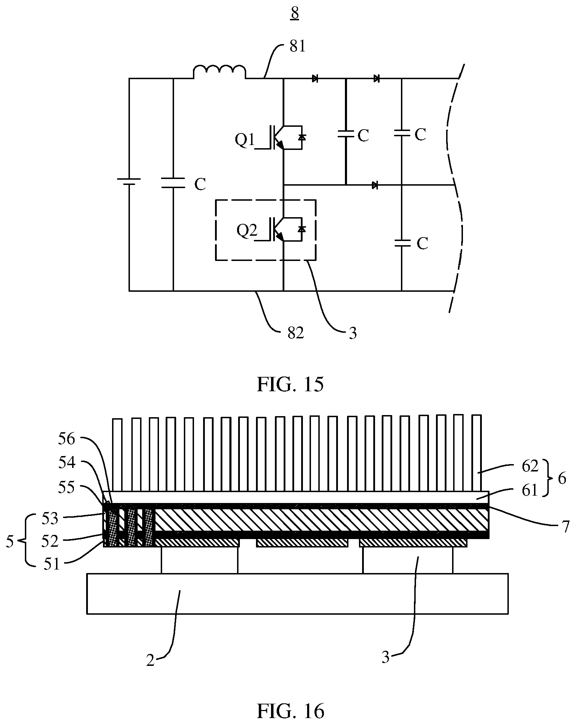

The power device 3 may be any suitable power device 3 in the power conversion circuit, provided that a voltage to ground the metal plate 33 remains unchanged. A direct current-direct current power conversion circuit (a DC-DC circuit, a type of power conversion circuit) is used as an example. FIG. 15 shows an example of a direct current-direct current power conversion circuit 8. With reference to FIG. 15, the direct current-direct current power conversion circuit 8 includes a first bridge arm between a positive bus 81 and a negative bus 82, the first bridge arm includes a first switching transistor Q1 and a second switching transistor Q2 that are connected in series (two switching transistors 321 with a same freewheeling direction), a drain or a collector of the second switching transistor Q2 is connected to the negative bus 82, and a level of the drain or the collector of the second switching transistor Q2 is stable.

With reference to FIGS. 14A-15, the switching transistor 321 of the die 32 in the power device 3 includes the second switching transistor Q2, and the drain or the collector of the switching transistor 321 is electrically connected to the metal plate 33. For example, in the power device 3 shown in FIG. 14A, the drain or the collector of the switching transistor 321 is fastened to the metal plate 33 and is electrically connected to the metal plate 33. For another example, in the power device 3 shown in FIG. 14B, the drain or the collector of the switching transistor 321 is fastened to the mounting plate 35, and the metal plate 33 is electrically connected to the mounting plate 35 through the conductive structure 36, so that the metal plate 33 is electrically connected to the drain or the collector of the switching transistor 321. If the metal plate 33 is connected to the negative bus 82, a level of the metal plate 33 is stable. In other words, the voltage to ground of the metal plate 33 remains unchanged.

In addition, when the substrate 5 is connected to the power device 3, the substrate 5. FIG may also be provided with the heat sink 6. FIG. 16 shows an example of a location of another heat sink 6. With reference to FIG. 16, the heat sink 6 is connected (soldered) to the second metal layer 53 of the substrate 5, and is configured to help the substrate 5 dissipate heat. The heat sink 6 may be entirely located in the apparatus housing 1, or the heat sink 6 may have a part in the apparatus housing 1 and have another part extending to the outside of the apparatus housing 1 through the opening 11. This is not specifically limited in this application.

In the embodiment shown in FIG. 16, the through hole 54 goes through the entire substrate 5, there is a filler 56 in the through hole 54, and the through hole 54 is sealed by using the filler 56. This reduces a possibility that solder 7 between the heat sink 6 and the substrate 5 enters the through hole 54, and facilitates stable connection between the heat sink 6 and the substrate 5. In some other embodiments, the filler 56 may not be placed in the through hole 54. In some other embodiments, when the substrate 5 is connected to the heat sink 6, the through hole 54 may not go through the entire substrate 5, for example, as in a form of through hole 54 in FIG. 13.

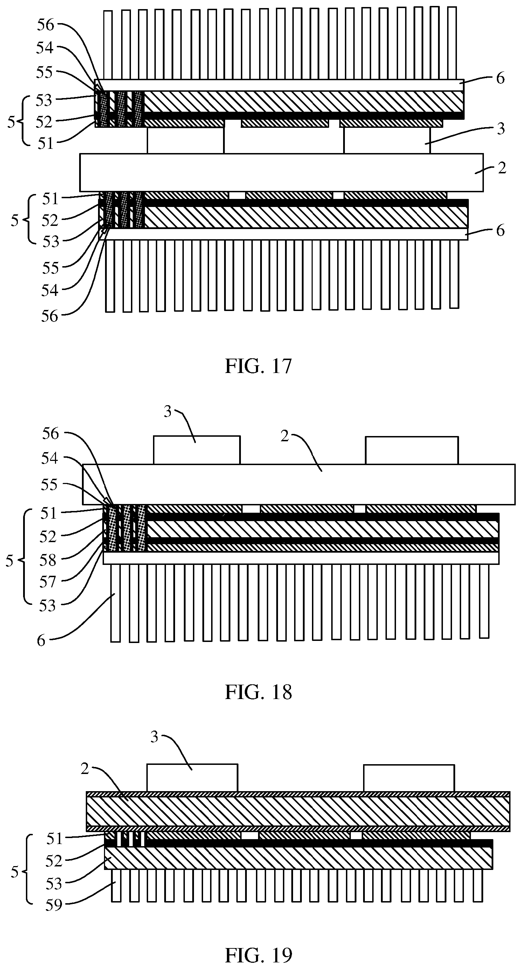

In addition, in some embodiments, two substrates 5 may be disposed. FIG. 17 shows an example of a location of still another substrate 5. With reference to FIG. 17, one substrate 5 (the lower substrate 5 in FIG. 17) is located on a side that is of the circuit board 2 and that is away from the power device 3, a first metal layer 51 of the substrate 5 is connected to the circuit board 2; and the other substrate 5 (the upper substrate 5 in FIG. 17) is located on a side that is of the power device 3 and that is away from the circuit board 2, and a first metal layer 51 of the another substrate 5 is connected to the power device 3. A voltage to ground of a part that is of the circuit board 2 and that is connected to the lower substrate 5 remains unchanged, and a voltage to ground of a part that is of the power device 3 and that is connected to the upper substrate 5 remains unchanged.

In an embodiment in which there are a plurality of substrates 5, one heat sink 6 may be disposed, and the heat sink 6 is connected to one of the substrates 5; or a plurality of heat sinks 6 may be disposed. For example, with reference to FIG. 17, one heat sink 6 is fastened to a side that is of each substrate 5 and that is away from the power device 3.

In addition, when a plurality of substrates 5 and a plurality of heat sinks 6 are disposed, if two heat sinks 6 are respectively located on different sides of the circuit board 2 (for example, in the case shown in FIG. 17), in an embodiment, the two heat sinks 6 may be entirely located in the apparatus housing 1; and in another embodiment, one heat sink 6 of the two heat sinks 6 may be entirely located in the apparatus housing 1, and the other heat sink 6 may have a part in the apparatus housing 1 and have another part extending to the outside of the apparatus housing 1 through the opening 11.

In an embodiment, the substrate 5 may further include more insulation layers and more metal layers. For example, the substrate 5 further includes a second insulation layer 57 and a third metal layer 58. FIG. 18 shows an example of a structure of another substrate 5. With reference to FIG. 18, the second insulation layer 57 and the third metal layer 58 are both located between the first insulation layer 52 and the second metal layer 53, and the second insulation layer 57 is fastened between the second metal layer 53 and the third metal layer 58. A material of the second insulation layer 57 may be any suitable insulation material. For example, the material of the second insulation layer 57 includes polypropylene (PP). In this way, the second metal layer 53 and the third metal layer 58 are insulated from each other, thermal resistance between the second metal layer 53 and the third metal layer 58 is reduced, and a heat dissipation capability of the substrate 5 is improved.

In addition, a material of the third metal layer 58 may be any suitable material, provided that the material of the third metal layer 58 is metal. In addition, the material of the first metal layer 51, the material of the second metal layer 53, and the material of the third metal layer 58 may be the same or different. In some cases, one side of the substrate 5 needs to be connected to the power device 3 or the circuit board 2, and the other side of the substrate 5 may be connected to an auxiliary heat dissipation structure such as the heat sink 6. Therefore, the materials of the first metal layer 51, the second metal layer 53, and the third metal layer 58 may be separately selected. For example, the materials of the first metal layer 51 and the second metal layer 53 are materials conducive to soldering (for example, copper); and the material of the third metal layer 58 is a material with a lower cost (for example, aluminum), or the material of the third metal layer 58 is a material with a lighter weight. In other words, when the substrate 5 includes a plurality of metal layers (for example, the first metal layer 51, the second metal layer 53, and the third metal layer 58), different materials may be selected for the metal layers according to a requirement. This facilitates connection (for example, soldering) between the substrate 5 and another structure, with other factors such as cost, weight, and heat conduction capability of the substrate 5 taken into consideration, allowing for a more flexible design of the substrate 5.

In the embodiment shown in FIG. 18, large parasitic capacitances may be caused both between the first metal layer 51 and the third metal layer 58 of the substrate 5 and between the third metal layer 58 and the second metal layer 53 of the substrate 5. Therefore, the through hole 54 further goes through the second insulation layer 57 and the third metal layer 58, and the conductor 55 is further connected to the third metal layer 58, so that levels of the substrate 5 and the heat sink 6 are stable. This reduces a possibility of interference to a signal in the power conversion apparatus 100.

In some other embodiments, the substrate 5 further includes a plurality of bosses 59 (which may be understood as a structure similar to fins 62) to help with heat dissipation. FIG. 19 shows an example of a structure of still another substrate 5. With reference to FIG. 19, the plurality of bosses 59 face away from the circuit board 2. For example, in the embodiment shown in FIG. 19, the plurality of bosses 59 are fastened (integrally connected or soldered) to the second metal layer 53. After the heat from the power device 3 is transferred to the substrate 5, a gap between two adjacent bosses 59 facilitates heat exchange between the bosses 62 and air, thereby improving heat dissipation efficiency of the power device 3.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power conversion apparatus, configured to perform power conversion on input electric energy for output, comprising:
an apparatus housing;
a circuit board, wherein the circuit board is fastened in the apparatus housing;
a power device, wherein the power device is fastened to the circuit board; and
a substrate, wherein the substrate is located in the apparatus housing, the substrate comprises a first metal layer, a second metal layer, and a first insulation layer fastened between the first metal layer and the second metal layer, and the first metal layer is connected to the circuit board or the power device;
the substrate further comprises a through hole and a conductor, the through hole goes through the first metal layer and the first insulation layer, and the conductor penetrates the through hole and connects the first metal layer and the second metal layer; and
during operation of the power conversion apparatus, a voltage to ground of a part that is of the circuit board or the power device and that is configured to connect to the first metal layer remains unchanged.

2. The power conversion apparatus according to claim 1, wherein the substrate is located on a side that is of the circuit board and that is away from the power device, the circuit board comprises a routing layer facing the substrate, the routing layer is connected to the first metal layer, and a voltage to ground of a part that is of the routing layer and that is configured to connect to the first metal layer remains unchanged.

3. The power conversion apparatus according to claim 1, wherein the substrate is located on a side that is of the power device and that is away from the circuit board; and
the power device comprises a packaging housing, a die, and a metal plate, the die is located in the packaging housing and is electrically connected to the metal plate, the metal plate protrudes from inside of the packaging housing to a side that is of the packaging housing and that is away from the circuit board, the metal plate is connected to the first metal layer, and a voltage to ground of the metal plate remains unchanged.

4. The power conversion apparatus according to claim 3, wherein the die comprises a switching transistor, a drain or a collector of the switching transistor is electrically connected to the metal plate, and the metal plate is electrically connected to a negative bus that is of a power conversion circuit in the power conversion apparatus.

5. The power conversion apparatus according to any one of claims 1 to 4, wherein the power conversion apparatus comprises a heat sink, the heat sink is located in the apparatus housing or at least a part of the heat sink is located outside the apparatus housing, the heat sink comprises a heat conducting plate and a plurality of fins, the heat conducting plate is located on a side that is of the substrate and that is away from the power device, and is connected to the second metal layer, and the plurality of fins are fastened to a surface that is of the heat conducting plate and that is away from the substrate.

6. The power conversion apparatus according to claim 5, wherein the through hole further goes through the second metal layer, and one end that is of the conductor and that is away from the circuit board is connected to the heat sink.

7. The power conversion apparatus according to claim 6, wherein the substrate further comprises a filler, the conductor is in a ring shape and is fastened to an inner surface of the through hole, and the filler is configured to be filled in space enclosed by the conductor; and
the filler comprises a metal block, and one end that is of the metal block and that is away from the circuit board is connected to the heat sink; or the filler comprises resin.

8. The power conversion apparatus according to any one of claims 1 to 4, wherein the substrate further comprises a second insulation layer and a third metal layer that are located between the first insulation layer and the second metal layer, and the second insulation layer is fastened between the second metal layer and the third metal layer; and
the through hole further goes through the second insulation layer and the third metal layer, and the conductor is further connected to the third metal layer.

9. The power conversion apparatus according to any one of claims 1 to 4, wherein a thickness of the first metal layer and a thickness of the second metal layer are both greater than a thickness of the first insulation layer.

10. A power cabinet, comprising a cabinet body and a plurality of power conversion apparatuses according to any one of claims 1 to 9, wherein the plurality of power conversion apparatuses are located in the cabinet body, and the plurality of power conversion apparatuses are connected in parallel.
